# EUROPÄISCHE PATENTANMELDUNG

(11) **EP 1 111 679 A2**
(43) Veröffentlichungstag der Anmeldung: **27.06.2001**
(21) Anmeldenummer: 00204615.9
(22) Anmeldetag: 18.12.2000
(51) Int. Cl.: H01L 27/01, H01L 21/70

(54) **Bauteil mit Dünnschichtschaltkreis**

(30) Priorität: 21.12.1999 DE 19961683
(71) Anmelder: Philips Corporate Intellectual Property GmbH, 52064 Aachen (DE); Koninklijke Philips Electronics N.V., 5621 BA Eindhoven (NL)
(72) Erfinder: Copetti, Carlo, Dr., c/o Philips Corporate, 52064 Aachen (DE); Sanders, Frans, c/o Philips Corporate, 52064 Aachen (DE); Fleuster, Martin, Dr., c/o Philips Corporate, 52064 Aachen (DE)
(74) Vertreter: Volmer, Georg, Dipl.-Ing.

(57) **Zusammenfassung**

Die Erfindung beschreibt einen Bauteil ausgerüstet mit Dünnschichtschaltkreis. Zur Realisierung des Bauteils mit Dünnschichtschaltkreis werden auf einem Substrat (1) aus einem isolierenden Material neben den Streifenleitungen Kondensatoren oder Kondensatoren und Widerstände oder Kondensatoren, Widerstände und Induktoren mittels Dünnschichttechniken schon direkt auf das Substrat aufgebracht. Durch die teilweise oder vollständige Integration von passiven Bauelementen wird ein Bauteil mit geringem Raumbedarf geschaffen.

## Beschreibung

Die Erfindung betrifft ein Bauteil ausgerüstet mit einem Dünnschichtschaltkreis auf einem Substrat aus einem isolierenden Material, ein Verfahren zur Herstellung eines Bauteiles mit Dünnschichtschaltkreis und einen Dünnschichtschaltkreis.

Die Entwicklung zahlreicher elektronischer Geräte ist durch folgende Trends geprägt: Miniaturisierung, niedrigere oder zumindest konstante Preise bei zunehmender Funktionalität, höhere Zuverlässigkeit und geringerer Energieverbrauch. Die Anzahl der passiven Bauelemente macht erfahrungsgemäß in zahlreichen Geräten der Konsumelektronik, beispielsweise in Fernsehgeräten oder Videorecordern, 70 % der vorhandenen Bauelemente aus. Aber auch die rasanten Entwicklungen im Mobilfunkbereich und die stete Miniaturisierung der schnurlosen Telefonapparate führen zu erhöhten Anforderungen an die einzelnen Komponenten.

Ein Schritt auf dem Weg zur steten Miniaturisierung stellt die sogenannte SMD-Technik dar. Die Grundlage für diese Technik bilden miniaturisierte Bauelemente (SMDs = Surface Mounted Devices), die direkt auf die Oberfläche von Leiterplatten oder Keramiksubstraten, die mit Streifenleitungen versehen sind, montiert werden. SMDs sind wesentlich kleiner als entsprechende herkömmlich bedrahtete Bauelemente. Bei konsequenter Ausnutzung können der Flächen- bzw. Raumbedarf und das Gewicht von Schaltungen halbiert bis gedrittelt werden. Auch kann durch optimalen Einsatz der SMD-Technik eine Kosteneinsparung erwirkt werden, da kleinere Leiterplatten verwendet werden können.

Mittels dieser Technik wird heute auch ein Leistungsverstärker-Modul für die Hochfrequenzeinheit eines mobilen Telefons hergestellt. Auf einem Substrat werden mit einer Drucktechnik Streifenleitungen aufgebracht. Das Substrat dient als Träger für aktive Bauelemente wie beispielsweise Verstärker und passive Bauelemente wie zum Beispiel Widerstände, Kondensatoren und Induktivitäten. Die aktiven Bauelemente werden dabei als ICs mittels einem Bond-Verfahren auf dem Substrat befestigt und die passiven Bauelemente als SMD-Bauelemente aufgelötet.

Durch weitere Miniaturisierung wird aber auch die Produktion, Handhabung und Montage von passiven SMD-Bauelementen immer schwieriger. Dies kann umgangen werden, indem integrierte passive Bauelemente (IPCs) zum Einsatz kommen. Bei dieser Technik werden passive Bauelemente, wie zum Beispiel Widerstände (R), Kondensatoren (C) oder Induktoren (L) zu untrennbaren Grundschaltungen und Systemen kombiniert. Durch Anwendung von Dünnschichttechniken erhält man mit Hilfe von Masken auf Trägerplatten aus einem isolierenden Material sogenannte Dünnschichtschaltkreise, die einer sehr stark verkleinerten gedruckten Schaltung entsprechen. Die Herstellung von Dünnschichtschaltkreisen ist bekannt und erfolgt im allgemeinen durch verschiedene aufeinanderfolgende Beschichtungs- und Strukturierungsprozesse. Um einen Dünnschichtschaltkreis, der aus einer Kombination von Widerständen, Kondensatoren oder Induktoren besteht, zu realisieren, sind verschiedene Schichten mit unterschiedlichen Formgebungen, Zusammensetzungen und Dicken aufzubringen.

Eine einfache Realisierung von Schaltungen mit unterschiedlichsten passiven wie aktiven Bauelementen gelingt durch Kombination von diskreten (SMD-)Bauelementen mit aktiven Bauelementen, die eine spezielle Funktion (zum Beispiel eine Filterfunktion) besitzen. Ein Nachteil ist aber, dass SMD-Bauelemente alle einzeln aufgelötet werden müssen. Durch die Lötstellen werden große Flächen benötigt, wodurch die Schaltungen sehr groß werden.

Der Erfindung liegt die Aufgabe zugrunde, ein Bauteil mit einem Dünnschichtschaltkreis mit passiven Bauelementen oder mit passiven und aktiven Bauelementen auf einem Substrat aus isolierendem Material zu schaffen, das einen geringen Raumbedarf hat.

Diese Aufgabe wird gelöst durch ein Bauteil ausgerüstet mit einem Dünnschichtschaltkreis auf einem Substrat aus einem isolierenden Material mit mindestens einem passiven Bauelement, welches wenigstens
eine erste strukturierte elektrisch leitende Schicht,
ein Dielektrikum,
eine zweite elektrisch leitende Schicht umfasst,
einer Schutzschicht,
sowie mindestens einem Kontaktloch, welches das Bauteil durchdringt und
einer Metallisierung, welche das Bauteil und das Kontaktloch bedeckt.
In diesem Dünnschichtschaltkreis sind auf einem Substrat nicht nur die Streifenleitungen, sondern auch mindestens ein passives Bauelement wie zum Beispiel ein Kondensator aufgebracht. Durch diese direkte Integration von passiven Bauelementen kann der gesamte Dünnschichtschaltkreis mit deutlich verringertem Raumbedarf realisiert werden.

In einer besonders bevorzugten Ausführungsform ist zwischen Substrat und der ersten strukturierten elektrisch leitenden Schicht eine Widerstandsschicht aufgebracht, so dass der Dünnschichtschaltkreis mindestens einen Widerstand enthält.

Es ist bevorzugt, dass das Substrat aus isolierendem Material ein keramisches Material, ein glaskeramisches Material, ein Glasmaterial oder ein keramisches Material mit einer Planarisierungsschicht aus Glas oder einem organischen Material enthält.

Ein Substrat aus diesen Materialien ist kostengünstig herzustellen und die Prozesskosten für diese Komponente können niedrig gehalten werden. In diesem Fall stellt das Substrat den Träger für diskrete Bauelemente und ICs dar.

Es ist besonders bevorzugt, dass das Substrat aus isolierendem Material Al₂O₃, Glas oder Al₂O₃ mit einer Planarisierungsschicht aus Glas oder einem organischem Material enthält.

Diese Materialien sind Dünnschichttechnik-kompatibel und weisen eine akzeptable Oberflächenrauhigkeit auf. Besonders Al₂O₃ zeichnet sich durch seine mechanische Stabilität und thermische Leitfähigkeit als Substrat aus.

Es ist weiterhin bevorzugt, dass zwischen Substrat und erster strukturierter elektrisch leitender Schicht oder zwischen Substrat und Widerstandsschicht eine Barriereschicht aufgebracht ist.

Durch eine Barriereschicht können Reaktionen mit dem Dielektrikum sowie rauhe Oberflächen der elektrisch leitenden Schichten, die zu Kurzschlüssen der Kondensatoren oder schlechten Hochfrequenzeigenschaften führen, vermieden werden.

Es ist vorteilhaft, dass die erste und zweite strukturierte elektrisch leitende Schicht Cu, Al dotiert mit Cu, Al dotiert mit Mg, Al dotiert mit Si oder Al dotiert mit Cu und Si enthält.

Es ist außerdem bevorzugt, dass die Widerstandsschicht NiₓCr_{y}Al_{z} (0 ≤ x ≤1, 0 ≤ y ≤ 1, 0 ≤ z ≤ 1), SiₓCr_{y}O_{z} (0 ≤ x ≤1, 0 ≤ y ≤ 1, 0 ≤ z ≤ 1), SiₓCr_{y}N_{z} (0 ≤ x ≤1, 0 ≤ y ≤ 1, 0 ≤ z ≤ 1), CuₓNi_{y} (0 ≤ x ≤1, 0 ≤ y ≤ 1) oder TiₓW_{y} (0 ≤ x ≤1, 0 ≤ y ≤ 1) enthält.

Diese Materialien werden nach der Abscheidung beispielsweise mittels lithographischer Prozesse verbunden mit Nass- und Trockenätzschritten entsprechend der Funktion, die die Schichten im Dünnschichtschaltkreis erfüllen sollen, strukturiert.

Es weiterhin vorteilhaft, dass das Dielektrikum Si₃N₄, SiO₂, SiₓO_{y}N_{z} (0 ≤ x ≤1, 0 ≤ y ≤ 1, 0 ≤ z ≤ 1) oder Ta₂O₅ enthält.

All diese Materialien weisen eine relative Dielektrizitätskonstante εᵣ > 4 auf und ermöglichen so hohe Kapazitätswerte auf kleinen Abmessungen.

Es ist bevorzugt, dass die Schutzschicht ein anorganisches Material enthält.

Durch die Schutzschicht werden die darunterliegenden Schichten vor mechanischer Beanspruchung und Korrosion durch Feuchtigkeit geschützt.

Weiterhin ist es bevorzugt, dass die strukturierte Metallisierung eine Basisschicht und eine Deckschicht enthält.

In dieser Ausführungsform wirkt die Basisschicht als Keimschicht für das galvanische Aufbringen der Deckschicht der strukturierten Metallisierung.

Es ganz besonders bevorzugt, dass auf der dem Dünnschichtschaltkreis entgegengesetzten Seite des Substrats diskrete Bauelemente aufgebracht sind.

Durch diese beidseitige Bestückung eines Wafers kann die Packungsdichte weiter erhöht werden.

Desweiteren betrifft die Erfindung auch ein Verfahren zur Herstellung eines Bauteiles ausgerüstet mit einem Dünnschichtschaltkreis auf einem isolierenden Substrat mit mindestens einem passiven Bauelement, bei dem
auf einem Substrat eine erste elektrisch leitende Schicht abgeschieden und strukturiert wird,
auf die erste strukturierte elektrisch leitende Schicht ein Dielektrikum abgeschieden wird,
auf das Dielektrikum eine zweite elektrisch leitende Schicht abgeschieden und strukturiert wird,
auf die zweite strukturierte elektrisch leitende Schicht eine Schutzschicht aufgebracht wird, Dielektrikum und Schutzschicht strukturiert werden,

wenigstens ein Kontaktloch, welches das Bauteil durchdringt, geschaffen wird und über dem Bauteil und dem Kontaktloch eine strukturierte Metallisierung aufgebracht wird.

In einer besonders bevorzugten Ausführungsform wird als erster Schritt auf dem Substrat eine Barriereschicht abgeschieden.

In einer ganz besonders bevorzugten Ausführungsform wird auf das Substrat oder auf die Barriereschicht zunächst eine Widerstandsschicht aufgebracht und strukturiert.

Es ist weiterhin bevorzugt, dass das Kontaktloch als erster Schritt oder nach Aufbringen der Schutzschicht geschaffen wird.

Je nach Herstellungsprozess kann das Kontaktloch nach Aufbringen der Schutzschicht geschaffen werden oder bereits bevor mittels Dünnschichttechniken die Streifenleitungen und passiven, integrierten Bauelemente aufgebracht werden.

Es ist bevorzugt, dass zur Herstellung der strukturierten Metallisierung zunächst eine Basisschicht über dem Bauteil und in dem Kontaktloch abgeschieden wird,
auf die Basisschicht eine Schicht aus Fotolack abgeschieden und entsprechend der gewünschten Strukturierung der Metallisierung strukturiert wird,
auf die Basisschicht eine Deckschicht abgeschieden wird und

der Fotolack und bestimmte Teile der Basisschicht entfernt werden.

Außerdem betrifft die Erfindung einen Dünnschichtschaltkreis auf einem Substrat aus einem isolierenden Material ausgerüstet mit mindestens einem passiven Bauelement, welches wenigstens
eine erste strukturierte elektrisch leitende Schicht,
ein Dielektrikum,
eine zweite elektrisch leitende Schicht umfasst,
einer Schutzschicht,
sowie mindestens einem Kontaktloch, welches das Substrat durchdringt und
einer strukturierten Metallisierung, welche die Schutzschicht und das Kontaktloch bedeckt.

Im folgenden soll die Erfindung anhand von fünf Figuren und drei Ausführungsbeispielen erläutert werden.

### Dabei zeigt

- Fig. 1: im Querschnitt den schematischen Aufbau eines erfindungsgemäßen Bauteils ausgerüstet mit einem Dünnschichtschaltkreis, welcher einen Kondensator, einen Widerstand und einen Streifenleitungsinduktor aufweist und
- Fig. 2 bis Fig. 5: ein Flow-Chart zur Herstellung eines Bauteil mit Dünnschichtschaltkreis.

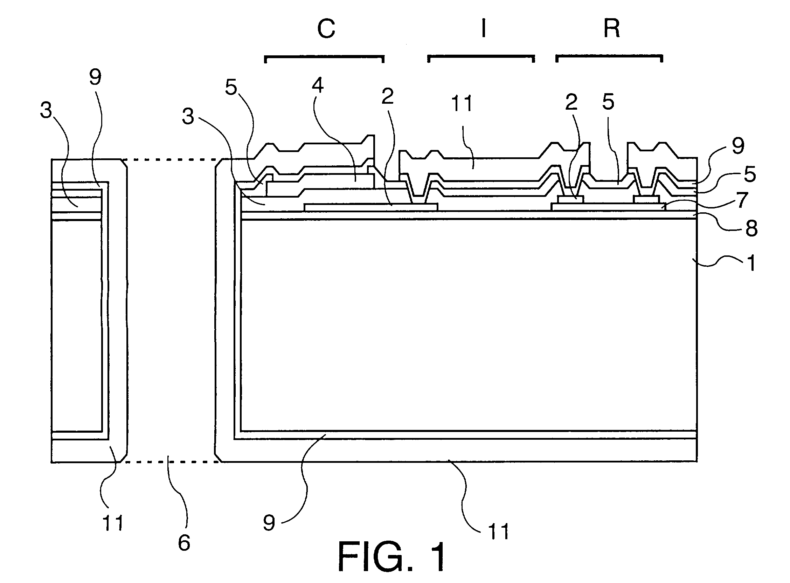

Gemäß Fig. 1 weist ein Bauteil mit Dünnschichtschaltkreis ein Substrat 1 auf, welches beispielsweise ein keramisches Material, ein glaskeramisches Material, ein Glasmaterial oder ein keramisches Material mit einer Planarisierungsschicht aus Glas oder einem organischen Material enthält. Bevorzugt enthält das Substrat 1 Al₂O₃, Glas, Al₂O₃ mit einer Planarisierungsschicht aus Glas, Polyimid oder Polybenzocyclobuten. Auf dieses Substrat 1 kann eine Barriereschicht 8 aufgebracht sein, welche beispielsweise Si₃N₄ enthält. Auf das Substrat 1 oder die Barriereschicht 8 ist eine Widerstandsschicht 7 abgeschieden und strukturiert. Diese strukturierte Widerstandsschicht 7 kann beispielsweise NiₓCr_{y}Al_{z} (0 ≤ x ≤ 1, 0 ≤ y ≤ 1, 0 ≤ z ≤ 1), SiₓCr_{y}O_{z} (0 ≤ x ≤1, 0 ≤ y ≤ 1, 0 ≤ z ≤ 1), SiₓCr_{y}N_{z} (0 ≤ x ≤1, 0 ≤ y ≤ 1, 0 ≤ z ≤ 1), CuₓNi_{y} (0 ≤ x ≤1, 0 ≤ y ≤ 1) oder TiₓW_{y} (0 ≤ x ≤1, 0 ≤ y ≤ 1) enthalten. Auf diese Widerstandsschicht 7 ist eine erste elektrisch leitende Schicht 2 aufgebracht und strukturiert. Auf dieser strukturierten ersten elektrisch leitenden Schicht 2 befindet sich ein Dielektrikum 3, welches im allgemeinen die ganze Fläche des Substrats 1 bedeckt und nur an bestimmten Stellen unterbrochen ist, um Vias zu der darunterliegenden ersten strukturierten elektrisch leitenden Schicht 2 herzustellen. Das Dielektrikum 3 kann beispielsweise Si₃N₄, SiO₂, SiₓO_{y}N_{z} (0 ≤ x ≤ 1, 0 ≤ y ≤ 1, 0 ≤ z ≤ 1) oder Ta₂O₅ enthalten. Auf dem Dielektrikum 3 ist eine zweite elektrisch leitende Schicht 4 abgeschieden und strukturiert. Die erste elektrisch leitende Schicht 2 sowie die zweite elektrisch leitende Schicht 4 können zum Beispiel Cu, Al, Al dotiert mit einigen Prozent Cu, Al dotiert mit einigen Prozent Si, Al dotiert mit einigen Prozent Mg oder Al dotiert mit einigen Prozent Cu und Si enthalten. Über dem gesamten Bereich des Substrats 1 befindet eine strukturierte Schutzschicht 5 aus einem anorganischen Material wie beispielsweise SiO₂, Si₃N₄ oder SiₓO_{y}N_{z} (0 ≤ x ≤ 1, 0 ≤ y ≤ 1, 0 ≤ z ≤ 1). Alternativ kann auch ein organisches Material wie zum Beispiel Polyimid oder Polybenzocyclobuten verwendet werden. Außerdem weist das Bauteil ausgerüstet mit einem Dünnschichtschaltkreis mindestens ein Kontaktloch 6 auf. Das Bauteil sowie das Kontaktloch 6 sind von einer strukturierten Metallisierung umgeben, welche wiederum eine Basisschicht 9 enthält. Es kann bevorzugt sein, dass auf die Basisschicht 9 eine oder mehrere weitere metallische Schichten aufgebracht sind. In diesem Fall fungiert die Basisschicht 9, welche beispielsweise Cr/Cu enthält, als Keimschicht für die galvanische Abscheidung einer Deckschicht 11. Die Deckschicht 11 enthält zum Beispiel Cu/Ni/Au.

Außerdem können an gegenüberliegenden Seiten des Bauteiles Stromzuführungen befestigt sein. Als Stromzuführung kann ein galvanischer SMD-Endkontakt aus Cr/Cu, Ni/Sn oder Cr/Cu, Cu/Ni/Sn oder Cr/Ni, Pb/Sn, ein Bump-end-Kontakt, eine Castellation aus Cr/Cu, Cu/Ni/Au, ein Ballgridarray aus einer Cr/Cu/Ni-Schicht mit einer aufgesetzten Kugel aus Sn oder PbSn-Legierung oder ein Landgridarray aus Cr/Cu eingesetzt werden.

Ein derartiges Bauteil ausgerüstet mit einem Dünnschichtschaltkreis kann beispielsweise bei der Herstellung eines Leistungsverstärkers für die Hochfrequenzeinheit eines mobilen Telefon verwendet werden.

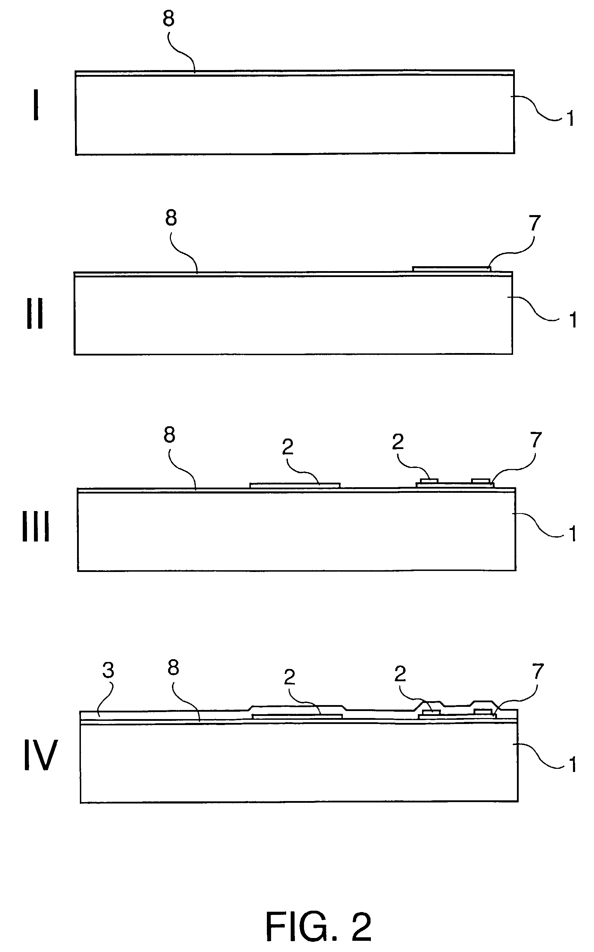

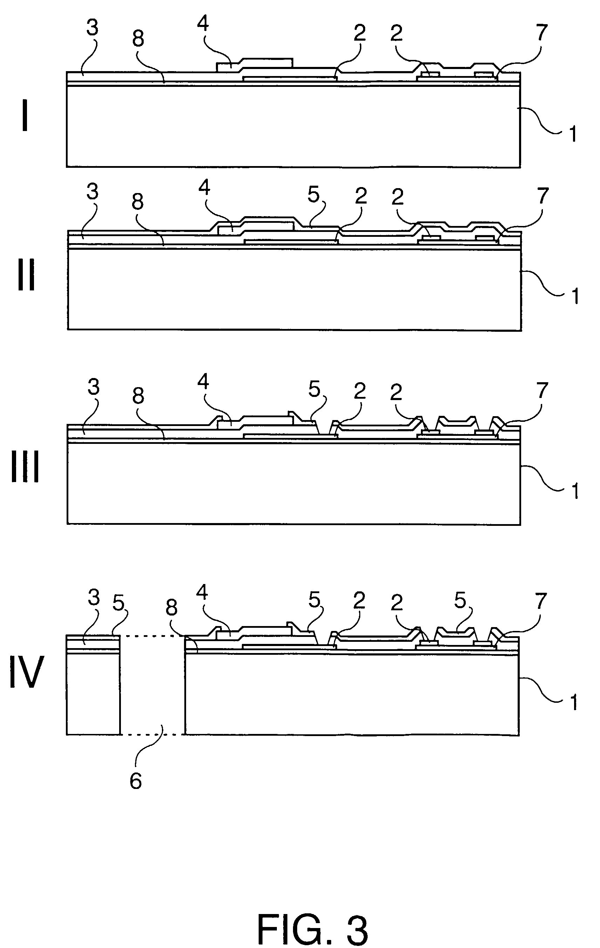

Zur Herstellung eines Bauteiles mit Dünnschichtschaltkreis kann gemäß Verfahrensschritt I in Fig. 2 zunächst auf einem Substrat 1, welches beispielsweise ein keramisches Material, ein glaskeramisches Material, ein Glasmaterial oder ein keramisches Material mit einer Planarisierungsschicht aus Glas oder einem organischen Material, wie zum Beispiel Polyimid oder Polybenzocyclobuten, enthält, eine Barriereschicht 8, welche zum Beispiel Si₃N₄ enthält abgeschieden werden. Auf die Barriereschicht 8 oder alternativ auf das Substrat 1 kann eine Widerstandsschicht 7 abgeschieden und strukturiert werden (Verfahrensschritt II in Fig. 2). Die Widerstandsschicht 7 kann beispielsweise NiₓCr_{y}Al_{z} (0 ≤ x ≤1, 0 ≤ y ≤ 1, 0 ≤ z ≤ 1), SiₓCr_{y}O_{z} (0 ≤ x ≤1, 0 ≤ y ≤ 1, 0 ≤ z ≤ 1), SiₓCr_{y}N_{z} (0 ≤ x ≤1, 0 ≤ y ≤ 1, 0 ≤ z ≤ 1), CuₓNi_{y} (0 ≤ x ≤1, 0 ≤ y ≤ 1) oder TiₓW_{y} (0 ≤ x ≤1, 0 ≤ y ≤ 1) enthalten. Auf die Barriereschicht 8 oder alternativ auf das Substrat 1 und auf Teile der Widerstandsschicht 7 wird eine erste elektrisch leitende Schicht 2 abgeschieden und strukturiert (Verfahrensschritt III in Fig. 2). Über die gesamte Fläche des Substrats 1 wird ein Dielektrikum 3 abgeschieden (Verfahrensschritt IV in Fig. 2). Das Dielektrikum 3 enthält bevorzugt Si₃N₄, SiO₂, SiₓO_{y}N_{z} (0 ≤ x ≤ 1, 0 ≤ y ≤ 1, 0 ≤ z ≤ 1) oder Ta₂O₅. Gemäß Verfahrensschritt I in Fig. 3 wird anschließend auf das Dielektrikum 3 eine zweite elektrisch leitende Schicht 4 abgeschieden und strukturiert. Die erste elektrisch leitende Schicht 2 sowie die zweite elektrisch leitende Schicht 4 können zum Beispiel Cu, Al, Al dotiert mit einigen Prozent Cu, Al dotiert mit einigen Prozent Si, Al dotiert mit einigen Prozent Mg oder Al dotiert mit einigen Prozent Cu und Si enthalten. Gemäß Verfahrensschritt II in Fig. 3 wird über dem gesamten Dünnschichtschaltkreis eine Schutzschicht 5 aus einem anorganischen Material aufgebracht. Als anorganisches Material kann zum Beispiel Si₃N₄, SiO₂ oder SiₓO_{y}N_{z} (0 ≤ x ≤ 1, 0 ≤ y ≤ 1, 0 ≤ z ≤ 1) verwendet werden. Alternativ kann auch ein organisches Material wie beispielsweise Polybenzocyclobuten oder Polyimid als Material für die Schutzschicht eingesetzt werden. Im Anschluss werden die Schutzschicht 5 und das Dielektrikum 3 strukturiert (Verfahrensschritt III in Fig. 3). Dies kann bei fotosensitiven Materialien mittels fotolithografischer Prozesse erfolgen oder anderenfalls mittels nass-chemischen oder trockenem Ätzens. Außerdem wird wenigstens ein Kontaktloch 6, welches das Substrat 1 durchdringt, mittels eines Lasers geschaffen (Verfahrensschritt IV in Fig. 3).

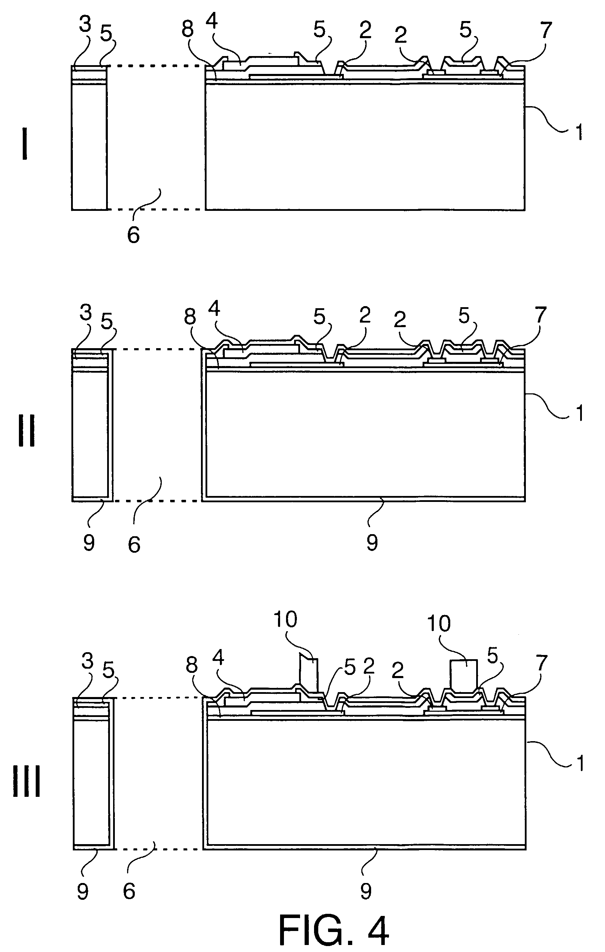

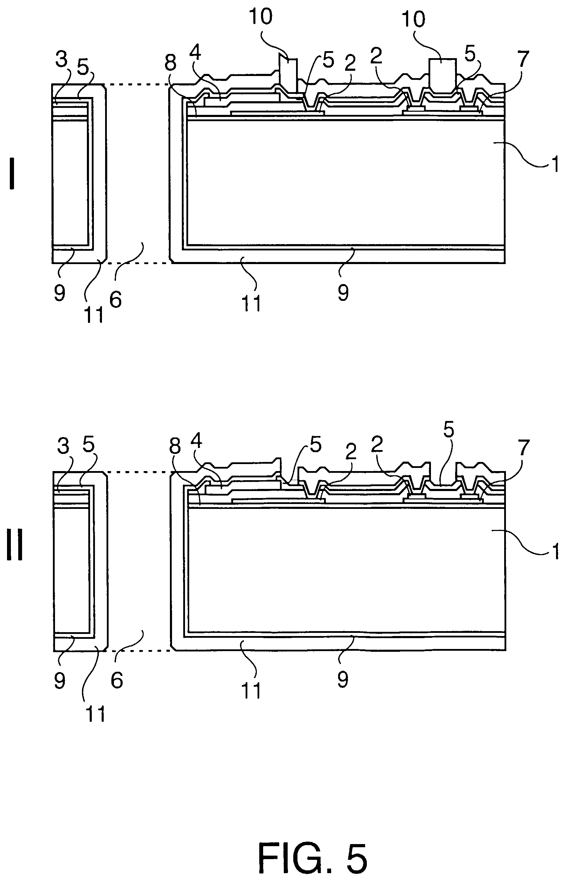

Gemäß Verfahrensschritt II in Fig. 4 wird zur Realisierung der strukturierten Metallisierung zunächst eine Basisschicht 9 aufgebracht, die das Bauteil und das Kontaktloch 6 bedeckt. Diese Basisschicht 9 enthält beispielsweise Cr/Cu. Im nächsten Schritt wird auf die Basisschicht 9 eine Schicht aus Fotolack 10 abgeschieden und mittels fotolithografischer Prozesse so strukturiert, dass die Schicht aus Fotolack 10 das Muster der gewünschten Strukturierung der Metallisierung aufweist (Verfahrensschritt III in Fig. 4). Anschließend wird galvanisch eine Deckschicht 11, welche beispielsweise Cu/Ni/Au enthält, auf die Basisschicht 9 abgeschieden. (Verfahrensschritt II in Fig. 5). Nach Entfernung des Fotolackes 10 werden die nicht mit der Deckschicht 11 bedeckten Teile der Basisschicht 9 mittels eines Ätzbades entfernt.

Außerdem können an gegenüberliegenden Seiten des Bauteiles Stromzuführungen befestigt sein. Als Stromzuführung kann ein galvanischer SMD-Endkontakt aus Cr/Cu, Ni/Sn oder Cr/Cu, Cu/Ni/Sn oder Cr/Ni, Pb/Sn, ein Bump-end-Kontakt, eine Castellation aus Cr/Cu, Cu/Ni/Au, ein Ballgridarray aus einer Cr/Cu/Ni-Schicht mit einer aufgesetzten Kugel aus Sn oder PbSn-Legierung oder ein Landgridarray aus Cr/Cu eingesetzt werden.

Alternativ kann ein Kontaktloch 6 geschaffen werden, bevor mittels Dünnschichttechniken die Streifenleitungen und passiven, integrierten Bauelemente aufgebracht werden.

Im folgenden werden Ausführungsformen der Erfindung erläutert, die beispielhafte Realisierungsmöglichkeiten darstellen.

### Ausführungsbeispiel 1

Auf ein Substrat 1 aus Al₂O₃ mit einer Planarisierungsschicht aus Glas ist eine strukturierte Barriereschicht 8 aus Si₃N₄ aufgebracht. Auf die Barriereschicht 8 wurde eine Widerstandsschicht 7 aus Ni₀₃Cr₀₆Al₀₁ abgeschieden und strukturiert. Auf einem Teil der Widerstandsschicht 7 sowie auf Teilen der Barriereschicht 8 wurde eine erste elektrische leitende Schicht 2 aus Al dotiert mit 4 % Cu abgeschieden und strukturiert. Im nächsten Schritt wurde über die gesamte Fläche des Substrates 1 ein Dielektrikum 3 aus Si₃N₄ abgeschieden. Auf dem Dielektrikum 3 wurde eine zweite elektrisch leitende Schicht 4 aus Al dotiert mit 4 % Cu abgeschieden und strukturiert. Der gesamte Dünnschichtschaltkreis wurde mit einer Schutzschicht 5 aus Si₃N₄ versehen. Das Dielektrikum 3 und die Schutzschicht 5 wurden strukturiert um eine spätere elektrische Kontaktierung der ersten elektrisch leitenden Schicht 2 und/oder der Widerstandsschicht 7 zu ermöglichen. Weiterhin wurden mehrere Kontaktlöcher 6, welche das Substrat 1 durchdringen, mittels eines Lasers geschaffen. Um das Bauteil sowie in die Kontaktlöcher 6 wurde eine Metallisierung aus einer Basisschicht 9 aus Cr/Cu und einer Deckschicht 11 aus Cu/Ni/Au aufgebracht. Außerdem wurden an beiden Seiten des Bauteiles Ballgridarrays mit einer Schicht aus Cr/Cu/Ni und Kugeln aus Sn als Stromzuführungen befestigt.

Durch weitere Bestückung mit entsprechenden passiven und aktiven Bauelementen wurde das Bauteil ausgerüstet mit einem Dünnschichtschaltkreis zur Herstellung eines Leistungsverstärker für die Hochfrequenzeinheit eines mobilen Telefons weiter verwendet.

### Ausführungsbeispiel 2

Auf ein Substrat 1 aus Al₂O₃ wurde eine Barriereschicht 8 aus Si₃N₄ aufgebracht und strukturiert. Auf die Barriereschicht 8 wurde eine erste elektrische leitende Schicht 2 aus Al dotiert mit 4 % Cu abgeschieden und strukturiert. Im nächsten Schritt wurde über die gesamte Fläche des Substrates 1 ein Dielektrikum 3 aus Ta₂O₅ abgeschieden und strukturiert. Auf dem Dielektrikum 3 wurde eine zweite elektrisch leitende Schicht 4 aus Al dotiert mit 4 % Cu abgeschieden und strukturiert. Der gesamte Dünnschichtschaltkreis wurde mit einer Schutzschicht 5 aus Si₃N₄ versehen. Weiterhin wurden mehrere Kontaktlöcher 6, welche das Substrat 1 komplett durchdringen, mittels eines Lasers geschaffen. Um das gesamte Bauteil sowie in die Kontaktlöcher 6 wurde eine Metallisierung aus einer Basisschicht 9 aus Cr/Cu und einer Deckschicht 11 aus Cu/Ni/Au aufgebracht. Außerdem wurden an beiden Seiten des Bauteiles Castellations aus Cr/Cu, Cu/Ni/Au als Stromzuführungen befestigt.
Das erhaltene Bauteil mit Dünnschichtschaltkreis wurde zur Herstellung eines Bandpassfilters in mobilen Telefonen weiter eingesetzt.

### Ausführungsbeispiel 3

Zur Herstellung eines Bauteil mit Dünnschichtschaltkreis wurde auf einem Substrat 1 aus Al₂O₃ mit einer Planarisierungsschicht aus Glas eine Barriereschicht 8 aus Si₃N₄ abgeschieden und strukturiert. Auf diese Barriereschicht 8 wurde eine Widerstandschicht 7 aus Ti_{0.1}W₀₉ abgeschieden und strukturiert. Anschließend wurde eine erste elektrisch leitende Schicht 2 abgeschieden und strukturiert. Auf diese erste strukturierte elektrisch leitende Schicht 2 wurde ein Dielektrikum 3 aus Si₃N₄ abgeschieden. Anschließend wurde auf dieses Dielektrikum 3 eine zweite elektrisch leitende Schicht 4 abgeschieden und strukturiert. Die erste elektrisch leitende Schicht 2 sowie die zweite elektrisch leitende Schicht 4 enthielten Al dotiert mit vier Prozent Si. Über dem Bauteil wurde eine Schutzschicht 5 aus Si₃N₄ aufgebracht. Zur elektrischen Kontaktierung wurden durch die Schutzschicht 5 und das Dielektrikum 3 Vias geätzt. Anschließend wurden mehrere Kontaktlöcher 6 mittels eines Lasers geschaffen, die das Substrat 1 komplett durchdringen. Im nächsten Schritt wurde um das Bauteil und in die Kontaktlöcher 6 eine Basisschicht 9, welche Cr/Cu enthielt, abgeschieden. Danach wurde auf der Basisschicht 9 eine Schicht aus Fotolack 10 aufgebracht. Diese Schicht aus Fotolack 10 wurde mittels fotolithografischer Prozesse so strukturiert, dass die Schicht aus Fotolack 10 das Muster der gewünschten Strukturierung der Metallisierung aufwies. Im nächsten Schritt wurde eine Deckschicht 11 aus Cu/Ni/Au galvanisch auf die Basisschicht 9 aus Cr/Cu abgeschieden und anschließend wurde der Fotolack 10 entfernt. Außerdem wurden an beiden Seiten des Bauteiles Ballgridarrays mit einer Schicht aus Cr/Cu/Ni und Kugeln aus Sn als Stromzuführungen befestigt.

## Patentansprüche

1. Bauteil ausgerüstet mit einem Dünnschichtschaltkreis auf einem Substrat (1) aus einem isolierenden Material mit mindestens einem passiven Bauelement, welches wenigstens
eine erste strukturierte elektrisch leitende Schicht (2),
ein Dielektrikum (3),
eine zweite elektrisch leitende Schicht (4) umfasst,
einer Schutzschicht (5),
sowie mindestens einem Kontaktloch (6), welches das Bauteil durchdringt und
einer Metallisierung, welche das Bauteil und das Kontaktloch (6) bedeckt.

2. Bauteil ausgerüstet mit einem Dünnschichtschaltkreis nach Anspruch 1,
dadurch gekennzeichnet,
dass zwischen Substrat (1) und erster strukturierter elektrisch leitender Schicht (2) eine Widerstandsschicht (7) aufgebracht ist.

3. Bauteil ausgerüstet mit einem Dünnschichtschaltkreis nach Anspruch 1,
dadurch gekennzeichnet,
dass das Substrat (1) aus isolierendem Material ein keramisches Material, ein glaskeramisches Material, ein Glasmaterial oder ein keramisches Material mit einer Planarisierungsschicht aus Glas oder einem organischen Material enthält.

4. Bauteil ausgerüstet mit einem Dünnschichtschaltkreis nach Anspruch 3,
dadurch gekennzeichnet,
dass das Substrat (1) aus isolierendem Material Al₂O₃, Glas oder Al₂O₃ mit einer Planarisierungsschicht aus Glas oder einem organischen Material enthält.

5. Bauteil ausgerüstet mit einem Dünnschichtschaltkreis nach Anspruch 1,
dadurch gekennzeichnet,
dass zwischen Substrat (1) und erster strukturierter elektrisch leitender Schicht (2) oder zwischen Substrat (1) und Widerstandsschicht (7) eine Barriereschicht (8) aufgebracht ist.

6. Bauteil ausgerüstet mit einem Dünnschichtschaltkreis nach Anspruch 1,
dadurch gekennzeichnet,
dass die erste und zweite strukturierte elektrisch leitende Schicht (2,4) Cu, Al dotiert mit Cu, Al dotiert mit Mg, Al dotiert mit Si oder Al dotiert mit Cu und Si enthält.

7. Bauteil ausgerüstet mit einem Dünnschichtschaltkreis nach Anspruch 2,
dadurch gekennzeichnet,
dass die Widerstandsschicht (7) NiₓCr_{y}Al_{z} (0 ≤ x ≤1, 0 ≤ y ≤ 1, 0 ≤ z ≤ 1), SiₓCr_{y}O_{z} (0 ≤ x ≤1, 0 ≤ y ≤ 1, 0 ≤ z ≤ 1), SiₓCr_{y}N_{z} (0 ≤ x ≤1, 0 ≤ y ≤ 1, 0 ≤ z ≤ 1), CuₓNi_{y} (0 ≤ x ≤1, 0 ≤ y ≤ 1) oder TiₓW_{y} (0 ≤ x ≤1, 0 ≤ y ≤ 1) enthält.

8. Bauteil ausgerüstet mit einem Dünnschichtschaltkreis nach Anspruch 1,
dadurch gekennzeichnet,
dass das Dielektrikum (3) Si₃N₄, SiO₂, SiₓO_{y}N_{z} (0 ≤ x ≤1, 0 ≤ y ≤ 1, 0 ≤ z ≤ 1) oder Ta₂O₅ enthält.

9. Bauteil ausgerüstet mit einem Dünnschichtschaltkreis nach Anspruch 1,
dadurch gekennzeichnet,
dass die Schutzschicht (5) ein anorganisches Material enthält.

10. Bauteil ausgerüstet mit einem Dünnschichtschaltkreis nach Anspruch 1,
dadurch gekennzeichnet,
dass die strukturierte Metallisierung eine Basisschicht (9) und eine Deckschicht (11) enthält.

11. Bauteil ausgerüstet mit einem Dünnschichtschaltkreis nach Anspruch 1,
dadurch gekennzeichnet,
dass auf der dem Dünnschichtschaltkreis entgegengesetzten Seite des Substrats diskrete Bauelemente aufgebracht sind.

12. Verfahren zur Herstellung eines Bauteiles ausgerüstet mit einem Dünnschichtschaltkreis auf einem Substrat (1) aus einem isolierenden Material mit mindestens einem passiven Bauelement,
dadurch gekennzeichnet,
dass auf einem Substrat (1) eine erste elektrisch leitende Schicht (2) abgeschieden und strukturiert wird,
auf die erste strukturierte elektrisch leitende Schicht (2) ein Dielektrikum (3) abgeschieden wird,
auf das Dielektrikum (3) eine zweite elektrisch leitende Schicht (4) abgeschieden und strukturiert wird,
auf die zweite strukturierte elektrisch leitende Schicht (2) eine Schutzschicht (5) aufgebracht wird,
Dielektrikum (3) und Schutzschicht (5) strukturiert werden,
wenigstens ein Kontaktloch (6), welches das Bauteil durchdringt, geschaffen wird und über dem Bauteil und dem Kontaktloch (6) eine strukturierte Metallisierung aufgebracht wird.

13. Verfahren nach Anspruch 12,
dadurch gekennzeichnet,
dass als erster Schritt auf dem Substrat (1) eine Barriereschicht (8) abgeschieden wird.

14. Verfahren nach Anspruch 12,
dadurch gekennzeichnet,
dass auf das Substrat (1) oder die Barriereschicht (8) zunächst eine Widerstandsschicht (7) aufgebracht und strukturiert wird.

15. Verfahren nach Anspruch 12,
dadurch gekennzeichnet,
dass das Kontaktloch (6) im ersten Schritt oder nach Aufbringen der Schutzschicht (5) geschaffen wird.

16. Verfahren nach Anspruch 12,
dadurch gekennzeichnet,
dass zur Herstellung der strukturierte Metallisierung zunächst eine Basisschicht (9) über dem Bauteil und in dem Kontaktloch (6) abgeschieden wird,
auf die Basisschicht (9) eine Schicht aus Fotolack (10) abgeschieden und entsprechend der gewünschten Strukturierung der Metallisierung strukturiert wird,
auf die Basisschicht (9) eine Deckschicht (11) abgeschieden wird und
der Fotolack (10) und bestimmte Teile der Basisschicht (9) entfernt werden.

17. Dünnschichtschaltkreis auf einem Substrat (1) aus einem isolierenden Material ausgerüstet mit mindestens einem passiven Bauelement, welches wenigstens
eine erste strukturierte elektrisch leitende Schicht (2),
ein Dielektrikum (3),
eine zweite elektrisch leitende Schicht (4) umfasst,
einer Schutzschicht (5),
sowie mindestens einem Kontaktloch (6), welches das Substrat (1) durchdringt und
einer strukturierten Metallisierung, welche die Schutzschicht (5) und das Kontaktloch (6) bedeckt.
